# EUROPEAN PATENT SPECIFICATION

(11) **EP 3 320 034 B1**
(45) Date of publication and mention of the grant of the patent: **24.08.2022**
(21) Application number: 16757065.4
(22) Date of filing: 06.07.2016
(51) Int. Cl.: C08K 3/00, C08K 3/08, B29C 45/00, C08J 3/20, C23C 14/22, B29B 9/16, B29K 105/16, C08K 3/015, C23C 14/20, B29B 9/12

(54) **METHOD FOR THE PRODUCTION OF NANOCOMPOSITE PLASTIC MATERIALS**
VERFAHREN ZUR HERSTELLUNG VON NANOKOMPOSIT-KUNSTSTOFFMATERIALIEN
PROCÉDÉ POUR LA PRODUCTION DE MATÉRIAUX PLASTIQUES NANOCOMPOSITES

(30) Priority: 06.07.2015 IT UB20151958; 08.07.2015 IT UB20152019
(43) Date of publication of application: 16.05.2018
(73) Proprietor: Universita' degli Studi di Roma " Tor Vergata", 00133 Roma (IT)
(72) Inventor: QUADRINI, Fabrizio, 00133 Roma (IT); SANTO, Loredana, 00173 Roma (IT); DI DOMENICO, Gildo, 00037 Segni (IT); GAGLIARDI, Donatella, 71017 Torremaggiore (IT); BELLISARIO, Denise, 00165 Roma (IT); TEDDE, Giovanni Matteo, 00173 Roma (IT)
(74) Representative: Bosman, Cesare
(86) International application number: PCT/IB2016/054047
(87) International publication number: WO 2017/006259

(56) References cited:
- WO-A1-2005/085339
- WO-A1-2013/021409
- WO-A2-2007/032001
- GB-A- 1 308 604
- KR-B1- 100 811 001
- US-A1- 2007 142 533
- US-B1- 8 101 680

## Description

The present invention relates to a method for the production of nanocomposite plastic materials.

### Background art

Nanocomposites with a polymer matrix are composites in which at least one of the dimensions of the dispersed particles (nano fillers) is in the range between 1 and 100 nm. The essential requirement is found in the "principle of nano-heterogeneity": the particles of nano filler must be dispersed individually in the polymer matrix so that the heterogeneous nature of the material can only be seen by nanoscale sampling. In theory, each nanometric particle should contribute in the same manner to the overall properties of the composite. The aspects linked to preparation are the focus of research activity in this field.

The advantage of using of nanoparticles inside polymer matrices is that great structural and functional performances with minimum filler content can be obtained. The effect is particularly intense in the case in which the properties dependent on the surface area of the filler (i.e. on the surface to volume ratio) are considered, such as barrier, wear resistance, electrical and thermal conductivity, and flame resistance properties, or aesthetic properties (in the case in which it acts as a dye). The structural properties, such as elastic modulus, toughness and breaking strength, can be considerably improved in relation to the properties of the base plastic. Typically, the contents in weight of the nanoparticles inside the nanocomposites are in the range between 0.1 and 0.5%, up to a maximum of 1%. In the case of composites filled with microparticles, it is necessary to start with filler levels of at least 5-10% for functional applications and up to 20-30% for structural applications.

Generally, the production of plastic matrix nanocomposites comprises a step of producing nanoparticles, a step of introducing the nanoparticles into a plastic matrix to form additives and a step of introducing the additives produced into the plastic matrix, which will form the base of the nanocomposite.

The need to provide a step of producing additives derives from the fact that the nanoparticles have the tendency to form agglomerates that become difficult to separate. This tendency means that the nanoparticles cannot be introduced directly into the polymer matrix that forms the final product by means of a simple mixing step, but require specific preliminary processing.

As it is immediately understood by those skilled in the art, the production of nanoparticles is a practice that has an extremely high incidence on the general cost of the production of nanocomposites, involving evident disadvantages in terms of productivity.

Moreover, it has been known for some time that nanoparticles have a high toxicity and that their use will be subject to severe restrictions.

The main methods for introducing nanoparticles into a plastic matrix regard in situ polymerization and melt compounding. In in situ polymerization, the polymer matrix must be formed on the appropriately separated and exfoliated nanoparticles. In practice, the monomer is absorbed, with the aid of a solvent, into the spaces between the layers of filler and this is followed by polymerization. The disadvantage of this technique is the difficulty that lies in the process, its limited applicability and above all in the impossibility of using macromolecules that are already polymerized (greatly limiting its application to thermoplastics).

In fact, in the case of thermoplastic polymers, the melt compounding technique is undoubtedly the most widely used, in which the high shear stresses present in the extruder are used to obtain break-up of the agglomerates or exfoliation of the appropriately functionalized nanoparticles. The main problem in this case is the difficulty in finding truly efficient filler-compatibilizer-polymer systems. By means of heating and applying shear strengths during mixing it is possible to obtain intercalation and, in some cases, exfoliation depending on the degree of penetration of the polymer. In actual fact, also in the case of a correct filler-compatibilizer-polymer system, the mixing conditions are very important: actually screw characteristics, processing temperatures and length of time inside the extruder determine the success of the end product. For example KR 100 811 001 B1 describes a method for coating a metallic component on a polymer particle surface by plasma discharge. The obtained polymer - metal composite particles are then injection molded.

Therefore, there was the need to provide a method for the preparation of nanocomposite plastic materials that overcomes the problems of the prior art.

The inventors of the present invention have developed a method capable of avoiding the preparation of nanoparticles and of ensuring correct dispersion of the nanoparticles (nano-heterogeneity) in the nanocomposite during a classic injection moulding step.

The present invention is based on a very innovative solution, which relates to fragmentation of a nanometric coating in the injection moulding step with consequent efficient dispersion of the fragmented particles (nano fillers) directly in the polymer base forming the end product.

### SUBJECT MATTER OF THE INVENTION

The subject matter of the present invention is a method for the preparation of nanocomposite plastic materials characterized in that it comprises:
- a coating step, in which the thermoplastic polymer granules with sizes from 0.5 to 5 mm are coated using a PVD sputtering technique with a coating layer from 1 to 100 nm of a material to be dispersed in a matrix of said thermoplastic polymer;
- an injection moulding step, in which the thermoplastic polymer granules coated in said coating step are plasticized and injected at high pressure into a closed mould.

The inventors have experimentally found that with polymer granules with sizes of less than 0.5 mm, the sputtering coating step does not take place efficiently, due to the vacuum preparation and air and plasma gas flushing steps.

The inventors have also experimentally found that when the coating layer has sizes greater than 100 nm, fragmentation in the injection moulding step does not produce the required nano-heterogeneity.

Preferably, said thermoplastic polymer granules have dimensions between 1 and 5 mm.

Preferably, the coating layer is made of Al, Ti, Cr, Cd, Co, Fe, Mg, Sc, Ag, Au, Eu, Hf, Pr, Cu and their alloys, borides, carbides, fluorides, nitrides, oxides, silicides, selenides, sulfides, tellurides, antimonides and arsenides.

Preferably, said thermoplastic polymer is in the group consisting of POM, PAN, ABS, SAN, PA6, PA66, PA12, PC, PET, PBT, PP, PE, LDPE, MDPE, HDPE, LLDPE, UHMWPE, PEI, PS, PEEK, PEKK, PSU, PPS, PVC.

Further described is a nanocomposite plastic material produced with the method forming the subject matter of the present invention.

Further is also described an additive for the production of a nanocomposite plastic material; said additive being characterized in that it consists of thermoplastic polymer granules with sizes from 0.5 to 5 mm and coated with a layer between 1 and 100 nm thick and of a material included in the group consisting of Al, Ti, Cr, Cd, Co, Fe, Mg, Sc, Ag, Au, Eu, Hf, Pr, Cu and their alloys, borides, carbides, fluorides, nitrides, oxides, silicides, selenides, sulfides, tellurides, antimonides and arsenides; said coating being produced by means of a PVD sputtering technique.

Preferably, said granules are adapted to produce a nanocomposite plastic material with antimicrobial and antibacterial properties, the coating layer being made of Ag.

### BRIEF DESCRIPTION OF THE DRAWINGS

Examples of embodiment are provided purely by way of nonlimiting example with the aid of the accompanying figures, wherein:
- Fig. 1 schematically illustrates the transformations of the material in the formation of the nanocomposite during injection moulding; and
- Figs. 2a and 2b are two microscope images illustrating the dispersion of nanometric particles of Ag in the nanocomposite produced in the example described.

### PREFERRED EMBODIMENT OF THE INVENTION

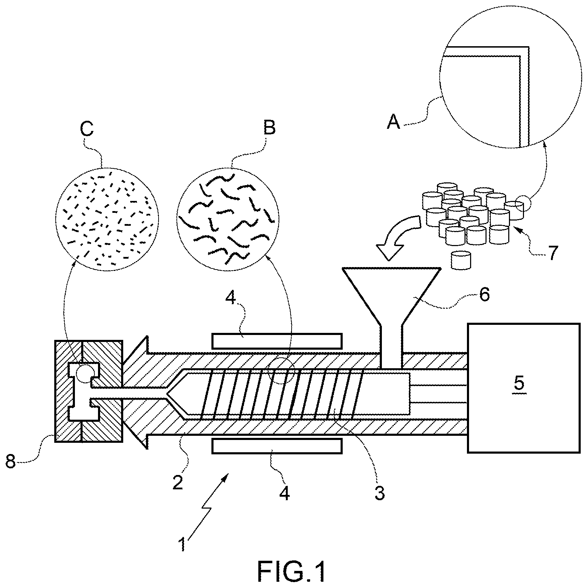

Fig. 1 donotes as a whole with 1 an injection moulding assembly illustrated schematically. The injection moulding assembly 1 comprises an injection cylinder 2, a plasticizing screw 3 housed inside the injection cylinder 2, a plurality of heaters 4 arranged around the injection cylinder 2, a drive motor 5 of the plasticizing screw 3, a hopper 6 for feeding the thermoplastic polymeric granules 7 into the injection cylinder 2 and a closed mould 8. Fig. 1 shows three enlargements (A - C), which illustrate respectively:
- (enlargement A) the coating layer arranged externally to the granules;
- (enlargement B) a first phase of fragmentation of the coating layer;
- (enlargement C) a last phase of fragmentation of the coating layer with the nano fillers dispersed nano-heterogeneously in the polymer matrix.
- Example -

By means of PVD RF magnetron sputtering, using an INFICON XTC/3 system for monitoring the film deposited, a 80 nm thick coating layer of 99.9% pure metallic silver was produced.

The polypropylene pellets (isotactic polypropylene (PP) Moplen HP500n by Lyondellbasell, with melt flow index (MFI) 12g/10min and density 0.9 g/cm³ at 23°C) with a very flat cylindrical shape of around 4 mm in diameter and 3 mm in height.

The pressure of the first sputtering chamber was 1.7×10⁻⁵ mbar, at a temperature of 35-40°C and with a distance of the pellets from the Ag target of 60 mm. The deposition parameters were 180 W DC, for 8 min, with only argon gas (purity of 99.999%) at the controllable pressure of 0.3-4 Pa.

The coated pellets were used for injection moulding of square samples for antibacterial analysis.

Moulding data: Fanuc Roboshot S-2000i 50B injection press, plate dimensions (80x80x3 mm³), mould temperature control (30°C), temperature of the material in the hopper (30°), injection speed (10 mm/s), clamping pressure (950 bar), mould clamping force (50 t), cylinder temperatures (from 190°C to 210°C), nozzle temperature (220°C), cooling time (10 s).

On the nanocomposites moulded and cut to the dimensions 30x30x3 mm³ antimicrobial tests were performed according to ISO22196: 2007 'Plastics - measurement of antibacterial activity on plastics surfaces' using bacterial strains Staphylococcus aureus, ATCC 6538, and Escherichia coli, ATCC 8739. After 24 hours from inoculation according to the standard (temperature 35 ± 1 °C with 90% humidity for 24 h) there was a 99.998% reduction in the presence of bacteria on the surface of the nanocomposite and an improvement of 98.44% in antibacterial properties compared to the surface of the same PP moulded without Ag nano coating.

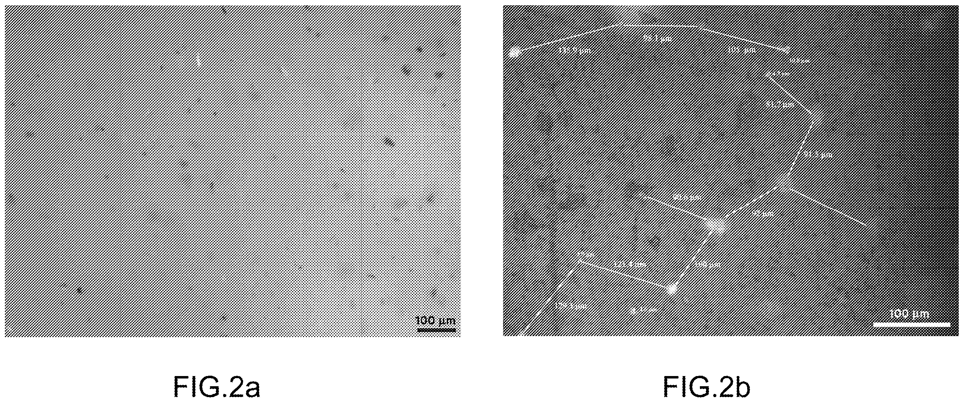

Figs. 2a and 2b show the micrographs of the samples produced as above.

The Ag nano fillers were dispersed in the polymer with a distance between adjacent metallic nanoparticles of around 100-150 µm. Moreover, the Ag metallic nano fillers measured have a thickness in the range between 60 nm and 80 nm and a surface between 5x5 µm² and 40x40 µm².

It was highlighted that the Ag nano fillers were substantially in the shape of flakes with: an average thickness of around 70 nm; a minimum equivalent diameter of around 5.65 µm; a maximum equivalent diameter of around 45.1 µm.

Moreover, it was measured that the fraction by weight of Ag in the nanocomposite was 0.18%, while the average distance between particles was around 130 µm.

### ADVANTAGES

As is evident from the description above, the method forming the subject matter of the present invention offers the advantage of eliminating the step of producing the nanoparticles and consequently of avoiding their use to form additives. These advantages translate necessarily into increased safety and increased productivity.

Moreover, with the method forming the subject matter of the present invention it is possible to ensure the involvement of only the polymer material concerned. In fact, in the prior art method, the additives are usually produced with a different polymer material compared to the one used to produce the matrix of the nanocomposite end product. This advantage translates necessarily into improved physical and mechanical properties of the nanocomposite end product, due to the absence of critical mechanical points caused by the proximity of different and often incompatible materials.

It is also important to stress the cost effectiveness of the method according to the invention. In this regard, it must be considered that to ensure the desired nano-heterogeneity of the nanoparticle substance in the polymer matrix, a processing step (injection moulding) already used in the normal preparation of nanocomposite plastic materials is used.

Finally, the use of thermoplastic polymer granules coated with a layer that will subsequently be subjected to fragmentation, in addition to ensuring visual confirmation of the presence of the substance that will be dispersed into the polymer matrix, also allows other additives to be used in the same polymer matrix without problems.

## Claims

1. Method for the preparation of nanocomposite plastic materials **characterized in that** it comprises:
- a coating step, in which the thermoplastic polymer granules with sizes from 0.5 to 5 mm are coated using a PVD sputtering technique with a coating layer from 1 to 100 nm of a material to be dispersed in a matrix of said thermoplastic polymer;
- an injection moulding/coating fragmentation step, in which the thermoplastic polymer granules coated in said coating step are plasticized and injected at high pressure into a closed mould

2. Method according to claim 1, **characterized in that** said thermoplastic polymer granules have sizes from 1 to 5 mm.

3. Method according to claim 1 or 2, **characterized in that** the coating layer is made of Al, Ti, Cr, Cd, Co, Fe, Mg, Sc, Ag, Au, Eu, Hf, Pr, Cu and their alloys, borides, carbides, fluorides, nitrides, oxides, silicides, selenides, sulfides, tellurides, antimonides and arsenides.

4. Method according to one of claims 1 to 3, **characterized in that** said thermoplastic polymer is in the group consisting of POM, PAN, ABS, SAN, PA6, PA66, PA12, PC, PET, PBT, PP, PE, LDPE, MDPE, HDPE, LLDPE, UHMWPE, PEI, PS, PEEK, PEKK, PSU, PPS, PVC.

## Patentansprüche

1. Verfahren zur Herstellung von Nanokomposit-Kunststoffmaterialien, **dadurch gekennzeichnet, dass** es umfasst:
- einen Beschichtungsschritt, bei dem das thermoplastische Polymergranulat mit einer Größe von 0,5 bis 5 mm mittels einer PVD-Sputtertechnik mit einer Beschichtungsschicht von 1 bis 100 nm eines in einer Matrix des thermoplastischen Polymers zu dispergierenden Materials beschichtet wird;
- einen Spritzguss- /Beschichtungsfragmentierungsschritt, bei dem das in diesem Beschichtungsschritt beschichtete thermoplastische Polymergranulat plastifiziert und unter hohem Druck in eine geschlossene Form gespritzt wird.

2. Verfahren nach Anspruch 1, **dadurch gekennzeichnet, dass** das thermoplastische Polymergranulat eine Größe von 1 bis 5 mm aufweist.

3. Verfahren nach Anspruch 1 oder 2, **dadurch gekennzeichnet, dass** die Beschichtungsschicht aus A1, Ti, Cr, Cd, Co, Fe, Mg, Sc, Ag, Au, Eu, Hf, Pr, Cu und Legierungen davon, Boriden, Carbiden, Fluoriden, Nitriden, Oxiden, Siliziden, Seleniden, Sulfiden, Telluriden, Antimoniden und Arseniden besteht.

4. Verfahren nach einem der Ansprüche 1 bis 3, **dadurch gekennzeichnet, dass** das thermoplastische Polymer aus der Gruppe ist, bestehend aus POM, PAN, ABS, SAN, PA6, PA66, PA12, PC, PET, PBT, PP, PE, LDPE, MDPE, HDPE, LLDPE, UHMWPE, PEI, PS, PEEK, PEKK, PSU, PPS, PVC.

## Revendications

1. Procédé pour la préparation de matériaux plastiques nanocomposites, **caractérisé en ce qu'**il comprend :
- une étape de revêtement, dans laquelle les grains en polymère thermoplastique ayant des dimensions de 0,5 à 5 mm sont recouverts, en utilisant une technique de pulvérisation PVD, d'une couche de revêtement de 1 à 100 nm en un matériau destiné à être dispersé dans une matrice dudit polymère thermoplastique ;
- une étape de moulage par injection/fragmentation de revêtement, dans laquelle les grains en polymère thermoplastique recouverts dans ladite étape de revêtement sont plastifiés et injectés à haute pression dans un moule fermé.

2. Procédé selon la revendication 1, **caractérisé en ce que** lesdits grains en polymère thermoplastique ont des dimensions de 1 à 5 mm.

3. Procédé selon la revendication 1 ou 2, **caractérisé en ce que** la couche de revêtement est en Al, Ti, Cr, Cd, Co, Fe, Mg, Sc, Ag, Au, Eu, Hf, Pr, Cu et leurs alliages, borures, carbures, fluorures, nitrures, oxydes, siliciures, séléniures, sulfures, tellurures, antimoniures et arséniures.

4. Procédé selon l'une des revendications 1 à 3, **caractérisé en ce que** ledit polymère thermoplastique est dans le groupe comprenant POM, PAN, ABS, SAN, PA6, PA66, PA12, PC, PET, PBT, PP, PE, LDPE, MDPE, HDPE, LLDPE, UHMWPE, PEI, PS, PEEK, PEKK, PSU, PPS, PVC.
